# EUROPEAN PATENT APPLICATION

(11) **EP 1 273 682 A1**
(43) Date of publication of application: **08.01.2003**
(21) Application number: 01917661.9
(22) Date of filing: 30.03.2001
(51) Int. Cl.: C25D 7/06

(54) **LASER HOLE DRILLING COPPER FOIL**

(30) Priority: 05.04.2000 JP 2000103505
(71) Applicant: Nikko Materials Company, Limited, Tokyo 105-8407 (JP)
(72) Inventor: SAKAMOTO, Masaru Nikko Mat. Co., Ltd. GNF Plant, Hitachi-city, Ibaraki 317-0056 (JP); KITANO, Kouji Nikko Mat. Co., Ltd. GNF Plant, Hitachi-city, Ibaraki 317-0056 (JP)
(74) Representative: Meddle, Alan Leonard
(86) International application number: JP0102706
(87) International publication number: WO01077420

(57) **Abstract**

There is provided a copper foil with an improved surface which makes the laser processing easier and is suitable for forming an interlayer connection microhole in the production of printed circuit boards. Specifically, the copper foil is such that it is used in laser beam drilling, characterized in that at least the portion of the surface thereof which the laser beam enters is plated with at least one or more kinds of metals comprising copper, so as to form a particle layer 0.01 to 3 µm thick thereon.

## Description

### BACKGROUND OF THE INVENTION

### Field of the Invention

The present invention relates to a copper foil which is excellent in hole processability in the laser beam drilling and allows efficient formation of via-holes in a printed circuit board.

The term "copper foil" herein used means not only copper foil itself, but also any copper clad laminates or laminates on which copper has been directly deposited (including those plated with copper).

### Description of the Prior Art

Recently, with the increasing wiring density, the laser beam drilling, which allows a finer processing than the conventional mechanical drilling, has been used more frequently in the production of electronic components and wiring boards both utilizing copper foil as a conductor.

However, when drilling a hole in a copper foil surface by illuminating the same with the carbon dioxide laser beam excellent in general-purpose properties, the reflectance of copper reaches almost 100 % at the wavelengths of the carbon dioxide laser beam, that is, around 10 µm, leading to a problem of extremely low laser processing efficiency.

In order to offset such a decrease in processing efficiency, a high output carbon dioxide laser drilling machine is required; however, when performing laser processing with high energy of such a high output carbon dioxide laser drilling machine , the resin board subj ected to drilling simultaneously with the copper foil is drilled to excess and damaged, which gives rise to a problem of being unable to drill a hole of intended shape.

Further, the amount of the splashed matter accompanying the high output laser processing becomes larger, which causes another problem of, for example, contamination of the laser drilling machine as well as the non-processed portion of the material having been subjected to the processing.

So, in order to avoid these problems, an attempt has been made to first make a hole in the copper foil portion by the chemical etching and then drill the resin portion by the laser beam. In this case, however, the number of the processes becomes larger than that of the case where the copper foil and the resin portion are drilled at a time, causing an increase in costs. Thus, this attempt also has a disadvantage.

On the other hand, as means for laser-processing a metal exhibiting a high reflectance at the laser beam wavelengths, a method has generally been adopted in which the surface of the metal is provided with a material with high absorptivity, so as to allow the material to absorb the laser beam and generate heat, and with the heat the metal is processed. Further, it has been known that roughing the material surface also allows a high processing efficiency.

Further, there has been proposed a method in which the surface of the copper foil is subjected to oxide treatment (black oxide treatment method) at the time of drilling, in order to increase the processing efficiency.

However, with any of the above proposals, the operations and treatments become complicated, and a sufficient laser processing efficiency cannot be obtained, considering how complicated they are. In addition, in the copper foil provided with the above-described surface treatment layer, the treatment layer tends to peel off since it is quite brittle and become a contamination source during the processing, which gives rise to another problem.

Further, there has been proposed a method in which copper foil itself is made thin so that it can be drilled by a low energy laser beam. However, since the thickness of the copper foil actually used varies from 9 µm to 36 µm, the copper foil can be made thin only for some cases. Furthermore, in order to perform drilling under the such low energy conditions, the copper foil required to be as extremely thin as 3 to 5 µm, which causes another problem of handling.

As described so far, although there have been proposed several methods of improving the copper foil in current use, the present situation is that any of the methods is not satisfactory for the laser beam drilling, in other words, the copper foil materials suitable for the laser processing have not been obtained yet.

### BRIEF SUMMARY OF THE INVENTION

### Object of the Invention

The present invention has been made in light of the above-described problems. Accordingly, the object of the present invention is to provide a copper foil with an improved surface which makes the laser beam drilling extremely easier and is suitable for forming an interlayer conneotionmicrohole in the production of printed circuit boards.

### Summary of the Invention

The present invention provides:
1. a copper foil for use in laser beam drilling,
   characterized in that it comprises a particle layer 0.01 to 3 µm thick which is formed at least on a surface thereof which a laser beam enters by plating the surface with at least one or more kinds of metals comprising copper; and
2. the copper foil for use in the laser beam drilling according to the above description 1, characterized in that it further comprises an over-plated coating which is formed on the surface of the particle layer formed by the metal plating without changing the surface configuration.

### BRIEF DESCRIPTION OF THE DRAWINGS

FIG. 1 is a photomicrograph of the roughened surface of example 1 obtainedby forming aparticle layer on the surface of electrodeposited copper foil ;
FIG. 2 is a photomicrograph of the surface of the electrodeposited copper foil of comparative example 1; and
FIG. 3 is a photomicrograph of the roughened surface of comparative example 2 obtained by forming a particle layer on the surface of electrodeposited copper foil .

### DETAILED DESCRIPTION OF THE PREFERRED EMBODIMENTS

After the intensive investigation while restricting attention to the surface types formed by the surface plating treatment, the present inventors found that good hole processability of copper foil was obtained when forming a particle layer 0.01 to 3 µm thick on the surface of the same by plating.

The surface of the copper foil having been subjected to the roughening treatment, formed by the fine particle layer 0.01 to 3 µm thick, could reflect the laser beam diffusely and thereby produce the same effect as that of optical absorption, which made it possible to ensure satisfactory hole processability even in the low energy carbon dioxide laser beam drilling.

In this case, the metals used in plating with copper contained therein may include Ni, Co, Sn, Zn, In and the alloys thereof, of which laser beam absorptivity and effect in laser beam drilling have already been confirmed. However, the metals are not necessarily limited to the above examples, there are some other metals applicable.

As described above, higher hole processability of copper foil in the laser beam drilling can be obtained by plating the surface of the copper foil which the laser beam enters with metals comprising copper to form a particle layer 0.01 to 3 µm thick.

The hole processability of copper foil in the laser beam drilling may also be improved by forming a particle layer 0.01 to 3 µm thick using the above-described metals, Ni, Co, Sn, Zn, In and the alloys thereof with no copper contained therein. And the hole processability was improved even by forming such a particle layer by plating, indeed. However, in the layer formed by such plate treatment, peel-off and dislodgement tended to occur, and in some cases, a phenomenon was observed that the layer easily peeled off due to a rub etc.

For example, when plating the surface of copper foil with Co alone in such a manner as to cause roughness therein, although satisfactory hole processabiliy was confirmed, the plated layer was brittle and the particles were exfoliated due to a rub.

When decreasing the deposition of the plating and roughness of the plated layer in order to overcome the problems of the above dislodgement and exfoliation, the hole processability became poor. Thus, forming the above-described metal layer allows the improvement in the hole processability in the laser beam drilling, indeed, although the layer still have several problems and cannot be said as a suitably treated layer.

And after further examination of various types plated metal layers on copper foil, the present inventors have found that plating adhesion can be increased by allowing the electro-plating composition, which is to form the above-described particle layer, to contain copper and thereby the peel-off and dislodgement of the treated layer can be effectively prevented.

Further, it is more effective to apply over-plating of one or more kinds of metals to the surface having been subj ected to roughening treatment, in order to prevent the above-described peel-off and dislodgement.

The over-plating may be performed under the normal plating conditions (normal plating) , but it must be performed so that the particle layer 0.01 to 3 µm thick should not be destroyed. In other words, the particle layer must exist substantially in the thickness range of 0.01 to 3 µm so as not to lower the hole processability in the laser beam drilling.

The plating used for the formation of the over-plated coating may be the same as or different from that of the roughening plating used for the formation of the above particle layer.

Preferably the plating metals used for the formation of the over-plated coating is selected from the group consisting of Ni, Co, Sn, Zn, In and the alloys thereof, just like the plating for the roughening, thereby the hole processability in the laser beam drilling can be further improved. As described so far, applying the over-plating to the surface having been subjected to roughening treatment allows the prevention of the peel-off and dislodgement of the treated layer, and consequently, ensures the satisfactory hole processability of copper foil in the laser beam drilling.

The copper foil for use in the present invention applies to both electrolytic and rolled copper foil. In order to use the copper foil for high density wiring, the thickness is desirably 18 µm or less. However, the copper foil of the present invention having been improved in hole processability. in the laser beam drilling is not intended to limited to the above thickness, and it applies to the thickness more than 18 µm.

The particle layer formed by the above-described types plating (the surface having been subjected to roughening treatment) can be applied partially to the portion of the copper foil surface which the laser beam enters or to the entire copper foil surface. It goes without saying that the plating treatment etc. described above should not damage the properties which the copper foil applied to printed circuit boards should have, and the treatment of the present invention fully satisfy this requirement.

After completing the above plating treatment, anti-corrosive treatment can be applied to the plated surface with a treatment solution containing chromium or zinc. The method of the anti-corrosive treatment or the treatment solution used therein is not limited to any specific one. This anti-corrosive treatment can be applied partially to the portion of the copper foil surface which the laser beam enters or to the entire copper foil surface.

Like the roughening treatment described above, it goes without saying that the anti-corrosive treatment should not damage the properties which the copper foil applied to printed circuit boards should have, and the anti-corrosive treatment of the present invention fully satisfy this requirement. This anti-corrosive treatment hardly affects the hole proccesability of the copper foil in the laser beam drilling.

When forming a plated layer of the present invention which consists of, for example, Cu, Ni, Co, Sn, Zn, In and the alloys thereof, the plating treatments described below are applicable. The plating treatments shown below are typical examples. The roughening treatment and over-plating can be performed while properly setting the conditions within the range shown below.

These examples are shown for illustrative purpose only and are not intended to limit the present invention.

### (Copper Plating Treatment)

Cu concentration: 1 to 30 g/L
Electrolysis solution temperature: 20 to 60°C, pH: 1.0 to 4.0
Current density: 5 to 60 A/dm², Plating duration: 0.5 to 4 seconds

### (Nickel Plating Treatment)

Ni concentration: 1 to 30 g/L
Electrolysis solution temperature: 25 to 60°C, pH: 1.0 to 4.0
Current density: 0.5 to 5 A/dm², Plating duration: 0.5 to 4 seconds

### (Cobalt Plating Treatment)

Co concentration: 1 to 30 g/L
Electrolysis solution temperature: 25 to 60°C, pH: 1.0 to 4.0
Current density: 0.5 to 5 A/dm², Plating duration: 0.5 to 4 seconds

### (Tin Plating Treatment)

Sn concentration: 5 to 100 g/L, Sulfuric acid: 40 to 150 g/L Electrolysis solution temperature: 25 to 40°C, pH: 1.0 to 4.0
Current density: 1.0 to 5 A/dm², Plating duration: 0.5 to 4 seconds

### (Indium Plating Treatment)

In concentration: 10 to 50 g/L, Sulfuric acid: 10 to 50 g/L Electrolysis solution temperature: 20 to 40°C, pH: 1.0 to 4.0
Current density: 1.0 to 20 A/dm², Plating duration: 0.5 to 4 seconds

### (Zinc-Cobalt Plating Treatment)

Zn concentration: 1 to 20 g/L, Co concentration: 1 to 30 g/L Electrolysis solution temperature: 25 to 50°C, pH: 1.5 to 4.0
Current density: 0.5 to 5 A/dm², Plating duration: 1 to 3 seconds

### (Copper-Nickel Plating Treatment)

Cu concentration: 5 to 20 g/L, Ni concentration: 5 to 20 g/L Electrolysis solution temperature: 25 to 50°C, pH: 1.0 to 4.0
Current density: 10 to 45 A/dm², Plating duration: 1 to 3 seconds

### (Copper-Cobalt Plating Treatment)

Cu concentration: 5 to 20 g/L, Co concentration: 5 to 20 g/L Electrolysis solution temperature: 25 to 50°C, pH: 1.0 to 4.0
Current density: 10 to 45 A/dm², Plating duration: 1 to 3 seconds

### (Zinc-Nickel Plating Treatment)

Zn concentration: 1 to 10 g/L, Ni concentration: 10 to 30 g/L
Electrolysis solution temperature: 40 to 50°C, pH: 3.0 to 4.0
Current density: 0.5 to 5 A/dm², Plating duration: 1 to 3 seconds

### (Cobalt-Nickel Plating Treatment)

Co concentration: 5 to 20 g/L, Ni concentration: 5 to 20 g/L Electrolysis solution temperature: 20 to 50°C, pH: 1.0 to 4.0
Current density: 0.5 to 10 A/dm², Plating duration: 1 to 180 seconds

### (Cu-Cobalt-Nickel Plating Treatment)

Co concentration: 1 to 15 g/L, Ni concentration: 1 to 15 g/L Cu concentration: 5 to 25 g/L
Electrolysis solution temperature: 20 to 50°C, pH: 1.0 to 4.0
Current density: 1.0 to 30 A/dm², Plating duration: 1 to 180 seconds

### [Examples]

In the following, the present invention will be described based on the examples. It is to be understood that these examples are to be shown as preferred examples of the present invention and not intended to limit the same, and that various changes and modifications may be made therein without departing from the spirit and the scope of the invention.

For comparison, comparative examples will be added in the latter part.

### (Example 1)

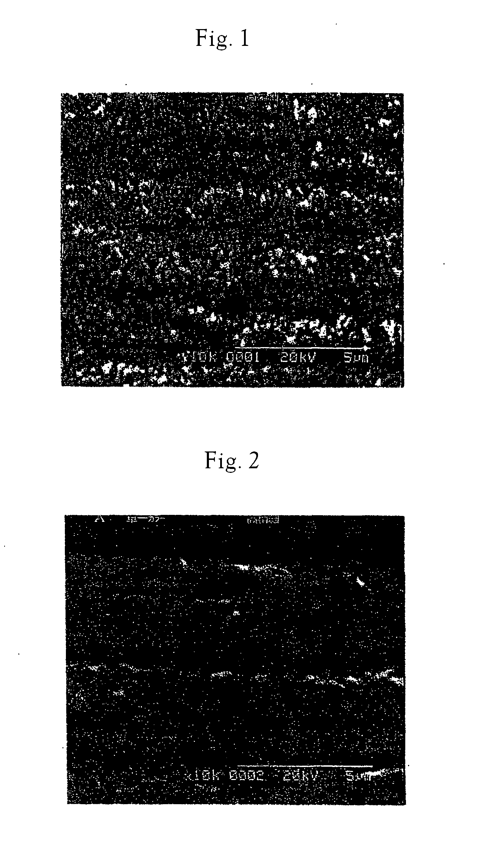

The shinny side (S side) of electrodeposited copper foil 12 µm thick was plated with a copper-cobalt-nickel alloy under the above-described conditions, so as to form a particle layer about 0.1 to 0.8 µm thick. FIG. 1 is a photomicrograph of the roughened surface of the particle layer formed on the S side of the.electrodeposited copper foil .

### (Example 2)

The shinny side (S side) of electrodeposited copper foil 12 µm thick was plated with a copper-cobalt-nickel alloy under the above-described conditions, so as to form a particle layer about 0.1 to 0.8 µm thick, the top of which was over-plated with a cobalt-nickel alloy under the above-described conditions (formation of a coating layer).

### (Comparative Example 1)

The electrodeposited copper foil 12 µm thick was used as it were. FIG. 2 is a photomicrograph of the surface of the electrodeposited copper foil .

### (Comparative Example 2)

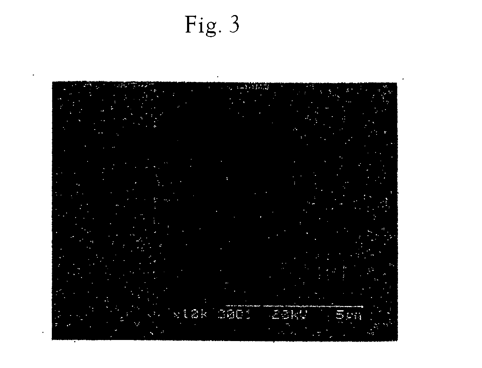

The shinny side (S side) of electrodeposited copper foil 12 µm thick was plated with cobalt under the above-described conditions, so as to form a particle layer about 0.3 to 1 µm thick. FIG. 3 is a photomicrograph of the roughened surface of the particle layer formed on the S side of the electrodeposited copper foil .

The samples of the above examples 1,2 and comparative examples 1,2 were formed into single sided boards using a prepreg (FR-4), and 100 spots per board were illuminated with the carbon dioxide laser beam under the following conditions and their opening ratio were compared. The results are shown in Table 1.

### (Laser Illumination Conditions)

Machine used: Carbon dioxide laser beam machine
Spot size: 144 µmφ
Pulse width: 32 µsec
Frequency: 400Hz, Shot number: 1 shot
Laser beam illumination energy: (Condition 1: 25 mJ/pulse,
Condition 2: 32 mJ/pulse)

**[Table 1]**

| | Laser Beam Opening ratio (Condition 1) | Laser Beam Opening ratio (Condition 2) | Powder Drop-off due to rub |
|---|---|---|---|
| Example 1 | 100 % | 100 % | ○ |
| Example 2 | 100 % | 100 % | ⓞ |
| Comparative Example 1 | 0 % | 9 % | ⓞ |
| Comparative Example 2 | 100 % | 100 % | × |
| × Powder Drop-off | | | |
| ○ A Trace of Powder Drop-off | | | |
| ⓞ No Powder Drop-off | | | |

In example 1, the opening ratios were 100 % under both conditions 1 and 2, which were extremely excellent results. In this case, although a trace quantity of powder drop-off (peel-off and dislodgement of the plated layer) due to a rub was observed, it was not a problem.

It was confirmed from this example that the copper-containing plating, which was for forming a particle layer of the present invention, was an effective means for preventing the peel-off and dislodgement of the plated layer.

In example 2, the opening ratios were 100 % under both conditions 1 and 2, which were extremely excellent results, like example 1. In this case, no powder drop-off (peel-off and dislodgement of the plated layer) due to a rub was observed.

Example 2 is a case where cobalt-nickel over-plating was applied after the particle layer of the present invention was formed, and it was confirmed from this example that the over-plating was an effective means for preventing the peel-off and dislodgement of the plated layer.

Comparative example 1 is a case where the copper foil was used as it was. Although no powder drop-off due to a rub was observed, the laser beam opening ratio was 0 % under the condition 1, that is, a hole could not be made in the copper foil by the laser beam drilling. Under condition 2, the opening ratio was as low as 9 %, which was extremely bad result as well.

In comparative example 2, the opening ratios were 100 % under both conditions 1 and 2, which were extremely excellent results.

However, powder drop-off (peel-off and dislodgement of the plated layer) due to a rub was observed, and it was so serious that the copper foil could not be practically used.

It is evident from the above that a hole cannot substantially be made in copper foil as it is by the carbon dioxide laser beam drilling. According to the present invention, a particle layer 0.01 to 3 µm thick is formed on the surface of copper foil, thereby the hole processability of the copper foil in the laser beam drilling is improved, as shown in the above example.

In addition, the phenomenon of powder drop-off can be prevented effectively by allowing the plating composition for use in the formation of the particle layer to contain copper. The use of over-plating makes the prevention more effective, and such means can be adopted according to the situation.

In the production of printed circuit boards, the present invention allows making a hole directly in copper foil and forming an via-hole in a simple and convenience manner by the low energy laser beam drilling using, for example, carbon dioxide laser beam, in addition, it is remarkably effective in preventing the peel-off and dislodgement of the plated layer caused by a rub.

## Claims

1. A copper foil for use in laser beam drilling, comprising a particle layer 0.01 to 3 µm thick which is formed at least on a surface thereof which the laser beam enters by plating said surface with at least one or more kinds of metals comprising copper.

2. The copper foil for use in laser beam drilling according to claim1, further comprising an over-plated coating which is formed on the surface of said particle layer formed by said metal plating without changing the surface configuration.
